# EUROPEAN PATENT APPLICATION

(11) **EP 2 450 385 A1**
(43) Date of publication of application: **09.05.2012**
(21) Application number: 10794077.7
(22) Date of filing: 25.06.2010
(51) Int. Cl.: C08F 20/18, C08F 2/38, C08K 3/08, C08L 33/14, H01B 1/20, H01L 31/04

(54) **BINDER RESIN FOR CONDUCTIVE PASTE, CONDUCTIVE PASTE, AND SOLAR CELL ELEMENT**

(30) Priority: 01.07.2009 JP 2009156997; 01.10.2009 JP 2009229896
(71) Applicant: Sekisui Chemical Co., Ltd., Osaka 530-8565 (JP)
(72) Inventor: YAMANAKA Isao, Mishima-gun Osaka 618-0021 (JP); MORIGUCHI Shintaro, Koka-shi Shiga 528-8585 (JP); YAMAUCHI Kenji, Mishima-gun Osaka 618-0021 (JP); HIRAIKE Hiroshi, Mishima-gun Osaka 618-0021 (JP); OMORI Kazuhiro, Mishima-gun Osaka 618-0021 (JP); SUGITA Daihei, Mishima-gun Osaka 618-0021 (JP)
(74) Representative: Hart-Davis, Jason
(86) International application number: PCT/JP2010/060817
(87) International publication number: WO 2011/001908

(57) **Abstract**

An object of the present invention is to provide a binder resin for a conductive paste, which can be used to obtain a conductive paste having a high conductive powder dispersibility, an ability to form high-aspect-ratio lines, and a low residual carbon content after firing. Further objects of the invention are to provide a conductive paste and a solar cell element produced using such a binder resin for a conductive paste.

The invention provides a binder resin for a conductive paste, which includes a polymer having a main chain composed of a segment derived from a (meth)acrylate monomer and having also a phosphoric acid-based component represented by general formula (1) below at an ω position thereon.

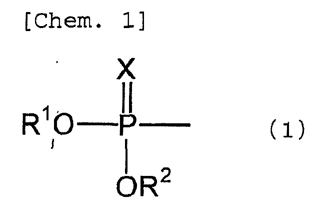

In general formula (1), X is an oxygen atom or a sulfur atom, and R¹ and R² are each a hydrogen atom, a hydrocarbon group having 1 to 13 carbon atoms, a hydroxyl group-containing group having 1 to 13 carbon atoms or an ester bond-containing group having 1 to 13 carbon atoms.

## Description

### TECHNICAL FIELD

The present invention relates to a binder resin for a conductive paste, which can be used to obtain a conductive paste having a high conductive powder dispersibility, an ability to form high-aspect-ratio lines, and a low residual carbon content after firing. The invention further relates to a conductive paste and a solar cell element produced using such a binder resin for a conductive paste.

### BACKGROUND ART

A process which involves, for example, depositing various essential layers on, respectively, the front surface or back surface of a semiconductor substrate, then printing and drying a conductive paste on these layers and firing the paste at a predetermined temperature is widely used to form, for example, electrodes, lines and other features on solar cell elements and the like. Conductive pastes used in such a method are produced by dispersing a metal powder having electrical conductivity (conductive powder) in a vehicle composition obtained by dissolving, in an organic solvent, resin ingredients which form a binder resin.

Cellulosic resins such as ethyl cellulose and nitrocellulose have hitherto been used as the binder resin in conductive pastes. For example, Patent Document 1 discloses a paste for a light-receiving surface electrode of a solar cell. The paste for a light-receiving surface electrode contains silver particles having a specific surface area of from 0.20 to 0.60 m²/g, a glass frit, a resin binder and a thinner. Ethyl cellulose is used as the resin binder.
However, in conductive pastes containing a cellulosic resin, because the thermal degradability of the cellulosic resin in the firing step is inadequate, residual carbon components remain in the resulting lines, as a result of which the adhesive strength of the conductive powder to the substrate declines and the lines have a tendency to separate from the substrate.

To resolve this problem, an acrylic resin having a relatively good thermal degradability is used as the binder resin. For example, Patent Document 2 discloses a process for manufacturing ceramic electronic components using a conductive paste for external electrodes which contains a given acrylic resin.
However, conductive pastes containing an acrylic resin have a poor conductive powder dispersibility and a non-uniform viscosity. For example, when forming the lines of a solar cell element, the paste drips or runs during printing, making the aspect ratio of the resulting lines small. "Aspect ratio" refers to the ratio of the cross-sectional height of the lines to the cross-sectional width (cross-sectional height/cross-sectional width). When the aspect ratio is smaller, the light-trapping ratio of the solar cell element worsens, lowering the energy conversion efficiency.

The addition of a phosphoric acid-based dispersant or the use of a resin having phosphoric acid-based side chains is known to increase the dispersibility of the conductive powder. For example, Patent Document 3 discloses a conductive resin which includes a specific phosphonate ester group-containing (meth)acrylamide polymer, and a binder for conductive metal pastes which contains such a conductive resin.
However, when a phosphoric acid-based dispersant or a resin having phosphoric acid-based side chains is included, even in conductive pastes containing an acrylic resin having a relatively good thermal degradability, the residual carbon content after firing increases, adversely affecting the performance of the lines.

### PRIOR ART DOCUMENTS

### PATENT DOCUMENTS

Patent Document 1: Japanese Kokai Publication 2007-235082 (JP-A 2007-235082)
Patent Document 2: Japanese Patent Publication No. 4096661
Patent Document 3: Japanese Patent Publication No. 4248551

### SUMMARY OF THE INVENTION

### PROBLEMS TO BE SOLVED BY THE INVENTION

An object of the present invention is to provide a binder resin for a conductive paste, which can be used to obtain a conductive paste having a high conductive powder dispersibility, an ability to form high-aspect-ratio lines, and a low residual carbon content after firing. Further objects of the invention are to provide a conductive paste and a solar cell element produced using such a binder resin for a conductive paste.

### MEANS FOR SOLVING THE PROBLEMS

The invention provides a binder resin for a conductive paste, which includes a polymer having a main chain composed of a segment derived from a (meth)acrylate monomer and having also a phosphoric acid-based component represented by general formula (1) below at an ω position thereon.

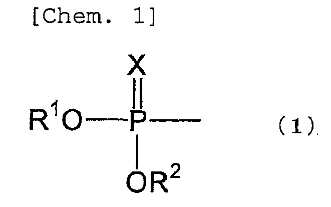

In general formula (1), X is an oxygen atom or a sulfur atom, and R¹ and R² are each a hydrogen atom, a hydrocarbon group having 1 to 13 carbon atoms, a hydroxyl group-containing group having 1 to 13 carbon atoms or an ester bond-containing group having 1 to 13 carbon atoms.
The invention is described in detail below.

The inventors have discovered that by using a binder resin for a conductive paste which includes a polymer having a main chain composed of a segment derived from a (meth)acrylate monomer and having also a phosphoric acid-based component represented by general formula (1) above at an ω position thereon, there can be obtained a conductive paste endowed with a high conductive powder dispersibility and a low residual carbon content after firing. The inventors have also discovered that such a conductive paste has an excellent printability, enabling high-aspect-ratio lines to be formed.

The binder resin for a conductive paste of the invention includes a polymer having a main chain composed of a segment derived from a (meth)acrylate monomer and having also a phosphoric acid-based component represented by general formula (1) below at an ω position thereon.

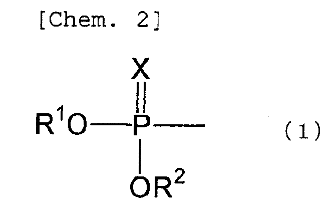

In general formula (1), X is an oxygen atom or a sulfur atom, and R¹ and R² are each a hydrogen atom, a hydrocarbon group having 1 to 13 carbon atoms, a hydroxyl group-containing group having 1 to 13 carbon atoms or an ester bond-containing group having 1 to 13 carbon atoms.
In the present specification, the phosphoric acid-based component represented by above general formula (1) which is present at the ω position on the polymer is also referred to simply as "the phosphoric acid-based component at the ω position." Moreover, in this specification, much as the initial carbon atom on a long-chain alkyl is called the α-position, the carbon atom at the tail end is called the ω-position. That is, "ω-position" refers to the last carbon in the polymer main chain making up the resin.

The binder resin for a conductive paste of the invention, because it has a main chain composed of a segment derived from a (meth)acrylate monomer, is endowed with an excellent thermal degradability compared with cellulosic resins. By using the binder resin for a conductive paste of the invention, a conductive paste having a low residual carbon content after firing can be obtained.
Illustrative, non-limiting, examples of the (meth)acrylate monomer include methyl (meth)acrylate, ethyl (meth)acrylate, propyl (meth)acrylate, n-butyl (meth)acrylate, tert-butyl (meth)acrylate, isobutyl (meth)acrylate, cyclohexyl (meth)acrylate, 2-ethylhexyl (meth)acrylate, isobornyl (meth)acrylate, n-stearyl (meth)acrylate, benzyl (meth)acrylate, hydroxyethyl (meth)acrylate, hydroxypropyl (meth)acrylate, polyoxyethylene (meth)acrylate and polyoxypropylene (meth)acrylate. These may be used singly or as combinations of two or more thereof. In the specification, "(meth)acrylate" signifies that either acrylate or methacrylate is acceptable, although methacrylate is preferred.

In general, resins including a polymer having a main chain composed of a segment derived from a (meth)acrylate monomer have an excellent thermal degradability compared with cellulosic resins, but effectively dispersing a conductive powder therein is difficult. By contrast, because the binder resin for a conductive paste of the invention has a phosphoric acid-based component represented by above general formula (1) at the ω position on the polymer, it is capable of effectively dispersing a conductive powder. As a result, a conductive paste which has an excellent printability and is able to form high-aspect-ratio lines can be produced using the binder resin for a conductive paste of the invention.
In addition, in the binder resin for a conductive paste of the invention, because the phosphoric acid-based component represented by above general formula (1) is located at the ω position on the polymer, an excellent thermal degradability can be retained even when the phosphoric acid-based component is introduced. Hence, by using the binder resin for a conductive paste of the invention, it is possible to produce a conductive paste having a low residual carbon content after firing.

In the binder resin for a conductive paste of the invention, when a phosphoric acid-based component aside from the phosphoric acid-based component at the ω position are present on the polymer, the content of such a phosphoric acid-based component other than the phosphoric acid-based component at the ω position is preferably less than 5% by weight of the overall polymer. At a content of the phosphoric acid-based component other than the phosphoric acid-based component at the ω position of 5% by weight or more, the thermal degradability of the binder resin for a conductive paste decreases, as a result of which it may not be possible to produce a conductive paste having a low residual carbon content after firing.

The method of producing the binder resin for a conductive paste of the invention, although not subject to any particular limitation, is exemplified by a method of obtaining a polymer by polymerizing a monomer mixture containing the above-described (meth)acrylate monomer and a compound having a phosphoric acid-based component and a thiol group.
The polymerization process is not subject to any particular limitation. Use may be made of a process employed in the conventional polymerization of (meth)acrylate monomers, such as free radical polymerization, living radical polymerization, iniferter polymerization, anionic polymerization and living anionic polymerization.

In addition to the above (meth)acrylate monomer, a compound having a phosphoric acid-based component and a thiol group may also be added to the above monomer mixture in order to introduce the phosphoric acid-based component represented by above general formula (1) to the ω position on the resulting polymer.
The above compound having a phosphoric acid-based component and a thiol group acts as a chain transfer agent; it is introduced only at the end of a polymer, and is not introduced at an intermediate position along the polymer or on a polymer side chain. For this reason, the phosphoric acid-based component represented by general formula (1) above is introduced only at the ω position of the resulting polymer. Introduction of the phosphoric acid-based component represented by above general formula (1) on the polymer can be confirmed by analysis of the presence or absence of phosphorus atoms via fluorescent X-ray analysis.

The above compound having a phosphoric acid-based component and a thiol group, although not subject to any particular limitation, is exemplified by thiophosphate esters represented by general formula (2) below and phosphate esters represented by general formula (3) or (4) below.

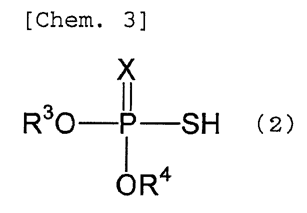

In general formula (2), X is an oxygen atom or a sulfur atom, and R³ and R⁴ are each a hydrogen atom, a hydrocarbon group having 1 to 13 carbon atoms, a hydroxyl group-containing group having 1 to 13 carbon atoms or an ester bond-containing group having 1 to 13 carbon atoms.

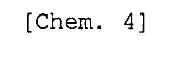

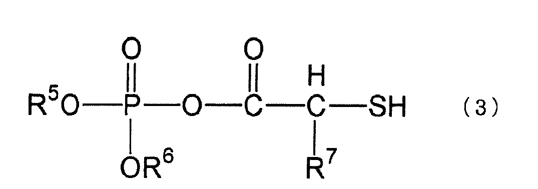

In general formula (3), R⁵, R⁶ and R⁷ are each a hydrogen atom, a hydrocarbon group having 1 to 13 carbon atoms, a hydroxyl group-containing group having 1 to 13 carbon atoms or an ester bond-containing group having 1 to 13 carbon atoms.

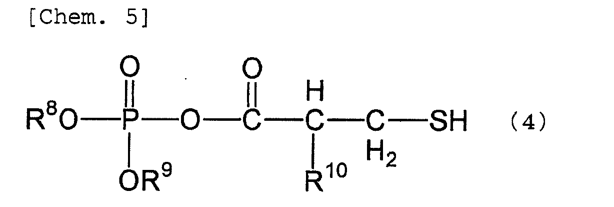

In general formula (4), R⁸, R⁹ and R¹⁰ are each a hydrogen atom, a hydrocarbon group having 1 to 13 carbon atoms, a hydroxyl group-containing group having 1 to 13 carbon atoms or an ester bond-containing group having 1 to 13 carbon atoms.

Illustrative, non-limiting, examples of the thiophosphate ester represented by above general formula (2) include bis(2-ethylhexyl) thiophosphate, diethyl thiophosphate, dimethyl thiophosphate, bis(2-ethylhexyl) dithiophosphate, diethyl dithiophosphate and dimethyl dithiophosphate.

Illustrative, non-limiting, examples of the phosphate ester represented by above general formula (3) include thioglycolic acid monophosphate, thioglycolic acid mono(dimethyl phosphate), thioglycolic acid mono(diethyl phosphate) and thioglycolic acid mono(di(ethylhexyl) phosphate).

Illustrative, non-limiting, examples of the phosphate ester represented by above general formula (4) include thiopropionic acid monophosphate, thiopropionic acid mono(dimethyl phosphate), thiopropionic acid mono(diethyl phosphate) and thiopropionic acid mono(di(ethylhexyl) phosphate).
These compounds having a phosphoric acid-based component and a thiol group may be used singly or as combinations of two or more thereof.

In the above monomer mixture, the content of the compound having a phosphoric acid-based component and a thiol group is not subject to any particular limitation, although the preferred lower limit per 100 parts by weight of the (meth)acrylate monomer is 0.01 parts by weight, and the preferred upper limit is 30 parts by weight. At a content of the compound having a phosphoric acid-based component and a thiol group below 0.01 parts by weight, the resulting binder resin for a conductive paste may be unable to effectively disperse a conductive powder, as a result of which it may not be possible to produce a conductive paste capable of forming high-aspect-ratio lines. On the other hand, at a content of the compound having a phosphoric acid-based component and a thiol group of more than 30 parts by weight, using the resulting binder resin for a conductive paste, it may not be possible to produce a conductive paste having a low residual carbon content after firing.

The above monomer mixture preferably includes a polymerization initiator.
Illustrative, non-limiting, examples of the polymerization initiator include conventional polymerization initiators used in the polymerization of (meth)acrylate monomers, such as azo-type polymerization initiators (e.g., AIBN), and organic peroxide-type polymerization initiators (e.g., peroxyketals, hydroperoxides, dialkyl peroxides, peroxydicarbonates, diacyl peroxides and peroxyesters).

In the above monomer mixture, the content of the polymerization initiator is not subject to any particular limitation, although the preferred lower limit is 0.01 parts by weight per 100 parts by weight of the (meth)acrylate monomer and the preferred upper limit is 30 parts by weight. At a polymerization initiator content below 0.01 parts by weight, the amount of initiator is inadequate, as a result of which the polymerization reaction may not arise. At a polymerization initiator content of more than 30 parts by weight, the amount of residual initiator increases, which may have an adverse influence on the residual carbon content after firing.

The glass transition temperature (Tg) of the binder resin for a conductive paste of the invention is not subject to any particular limitation, although the preferred lower limit is 10°C and the preferred upper limit is 80°C. At a glass transition temperature below 10°C, the binder resin for a conductive paste becomes too soft and is thus unable to support the subsequently described conductive powder such as silver powder, as a result of which it may not be possible to produce a conductive paste capable of forming high-aspect-ratio lines. On the other hand, at a glass transition temperature above 80°C, the binder resin for a conductive paste becomes hard, which may have an adverse influence on the printability of the conductive paste.

The number-average molecular weight of the binder resin for a conductive paste of the invention is not subject to any particular limitation, although the preferred lower limit in the polystyrene-equivalent number-average molecular weight, as measured by gel permeation chromatography (GPC), is 5,000 and the preferred upper limit is 30,000. At a number-average molecular weight below 5,000, the binder resin for a conductive paste becomes too soft and is thus unable to support the subsequently described conductive powder such as silver powder, as a result of which it may not be possible to produce a conductive paste capable of forming high-aspect-ratio lines. On the other hand, at a number-average molecular weight above 30,000, the tack of the binder resin for a conductive paste becomes too strong, as a result of which the paste obtained therewith may have an adverse influence on the printability of the conductive paste, such as stringiness or poor plate separation.
The column used when measuring the polystyrene-equivalent number-average molecular weight by gel permeation chromatography is exemplified by an LF-804 column available from Shoko Co., Ltd.

The binder resin for a conductive paste of the invention has a residual carbon content when heated to 600°C at a rate of temperature rise of 10°C/min of preferably 1% by weight or less. At a residual carbon content in excess of 1% by weight, it may not be possible, using the binder resin for a conductive paste, to produce a conductive paste having a low residual carbon content after firing.
The residual carbon content can be measured by analysis using a carbon/sulfur analyzer (EMIA-820) after firing.

No particular limitation is imposed on applications for the binder resin for a conductive paste of the invention. For example, by mixture with other ingredients such as a conductive powder and an organic solvent, use as a conductive paste to form electrodes, electrically conductive layers and electrically conductive lines in solar cell elements, ceramic electronic components and the like is possible. Use as a conductive paste to form electrically conductive layers or electrically conductive lines in solar cell elements is especially preferred.

In a further aspect, the invention also provides a conductive paste containing the binder resin for a conductive paste of the invention, a conductive powder and an organic solvent.
In the conductive paste of the invention, the content of the binder resin for a conductive paste of the invention, although not subject to any particular limitation, is preferably as small as is allowable for printing, with the preferred lower limit relative to the overall conductive paste being 1% by weight, and the preferred upper limit being 20% by weight. At a content of the binder resin for a conductive paste of the invention of less than 1% by weight, the dispersibility of the conductive powder in the resulting conductive paste may decrease. On the other hand, at a content of the binder resin for a conductive paste of the invention of more than 20% by weight, the residual carbon content after firing the resulting conductive paste increases, which may have an adverse influence on the performance of lines formed using the conductive paste.

The conductive paste of the invention includes a conductive powder.
The conductive powder is an ingredient which confers the paste with electrical conductivity. No particular limitation is imposed on the conductive powder; use may be made of a commonly employed conductive powder, illustrative examples of which include silver powder, copper powder, nickel powder, and oxides, carbonates and acetates thereof. Of these, a silver powder is preferred. These may be used singly or as combinations of two or more thereof.

In the conductive paste of the invention, the content of the conductive powder, although not subject to any particular limitation, has a preferred lower limit of 10% by weight and a preferred upper limit of 95% by weight based on the overall conductive paste. At a conductive powder content below 10% by weight, the resulting conductive paste may have a reduced printability, which may make it impossible to form high-aspect-ratio lines. At a conductive powder content in excess of 95% by weight, paste formation may be difficult.

The conductive paste of the invention includes an organic solvent.
The organic solvent has a boiling point at one atmosphere with a preferred lower limit of 150°C and a preferred upper limit of 350°C. By satisfying such a range, vaporization of the organic solvent during printing is suppressed, resulting in a stable conductive paste viscosity and increased printability, thus enabling high-aspect-ratio lines to be formed.

The organic solvent having a boiling point lower limit of 150°C and boiling point upper limit of 350°C is not subject to any particular limitation, and is exemplified by glycol-based solvents, glycol-based ester solvents, carbitol-based solvents and terpineol-based solvents.
Illustrative, non-limiting, examples of glycol-based solvents include ethylene glycol, triethylene glycol, tetraethylene glycol, pentaethylene glycol, hexaethylene glycol, propylene glycol, phenylpropylene glycol, tripropylene glycol and benzyl glycol.

Illustrative, non-limiting, examples of glycol-based ester solvents include ethylene glycol monomethyl ether, ethylene glycol ethyl ether, ethylene glycol monobutyl ether, ethylene glycol dodecyl ether, ethylene glycol monomethyl ether acetate, ethylene glycol ethyl ether acetate, ethylene glycol monobutyl ether acetate, ethylene glycol dodecyl ether acetate, ethylene glycol dimethyl ether, ethylene glycol diethyl ether, ethylene glycol dibutyl ether, ethylene glycol ethyl methyl ether, diethylene glycol monomethyl ether, diethylene glycol monoethyl ether, diethylene glycol mono-n-butyl ether, diethylene glycol monoisobutyl ether, diethylene glycol monohexyl ether, diethylene glycol monooleate, diethylene glycol monophenyl ether, diethylene glycol monomethyl ether acetate, diethylene glycol monoethyl ether acetate, diethylene glycol mono-n-butyl ether acetate, diethylene glycol monoisobutyl ether acetate, diethylene glycol monohexyl ether acetate, diethylene glycol monooleate acetate, diethylene glycol monophenyl ether acetate, diethylene glycol monolaurate, diethylene glycol dimethyl ether, diethylene glycol diethyl ether, diethylene glycol di-n-butyl ether, triethylene glycol diacetate, triethylene glycol dimethyl ether, triethylene glycol monobutyl ether, triethylene glycol monostearate, triethylene glycol monobenzyl ether, propylene glycol monomethyl ether, propylene glycol monomethyl ether acetate, propylene glycol diacetate, dipropylene glycol, dipropylene glycol monomethyl ether, dipropylene glycol monopropyl ether, dipropylene glycol monobutyl ether, dipropylene glycol monomethyl ether acetate, dipropylene glycol monopropyl ether acetate, dipropylene glycol monobutyl ether acetate, tripropylene glycol monomethyl ether, tripropylene glycol monomethyl ether acetate, tetraethylene glycol, tetraethylene glycol dodecyl ether, tetraethylene glycol monooctyl ether, tetraethylene glycol monomethyl ether, pentaethylene glycol dodecyl ether, heptaethylene glycol dodecyl ether, hexaethylene glycol dodecyl ether, ethylene glycol monophenyl ether, diethylene glycol monophenyl ether, ethylene glycol monobenzyl ether, diethylene glycol monobenzyl ether and propylene glycol monophenyl ether.

Illustrative, non-limiting, examples of carbitol-based solvents include octaethylene glycol monododecyl ether butyl carbitol and butyl carbitol acetate.

Illustrative, non-limiting, examples of terpineol-based solvents include terpineol, terpineol acetate, dihydroterpineol and dihydroterpineol acetate.

Illustrative examples of the organic solvent having a boiling point lower limit of 150°C and boiling point upper limit of 350°C include Texanol, benzyl acetate, isophorone, butyl lactate, dioctyl phthalate, dioctyl adipate, benzyl alcohol, cresol, methyl phenylacetate, ethyl phenylacetate, ethyl benzoate, methyl benzoate and benzyl alcohol.
These organic solvents having a boiling point lower limit of 150°C and boiling point upper limit of 350°C may be used singly or as combinations of two or more thereof.

In the conductive paste of the invention, the content of the organic solvent is not subject to any particular limitation. The preferred lower limit with respect to the overall conductive paste is 5% by weight, and the preferred upper limit is 90% by weight. At an organic solvent content outside the above range, the resulting conductive paste may have a lower printability, as a result of which it may not be possible to form high-aspect-ratio-lines.

The conductive paste of the invention may contain glass frit.
By adding glass frit, the adhesion when the conductive paste is printed and fired to form lines can be increased. In the manufacture of solar cell elements in particular, in cases where the conductive paste of the invention is used to form lines following the formation of an antireflection layer on the semiconductor layer, by adding glass frit, good physical adhesion is carried out, in addition to which the antireflection layer is corroded by interactions between the conductive powder and the glass frit, enabling good electrical contact to be achieved between the lines and the semiconductor layer.

The glass frit is not subject to any particular limitation. Use may be made of any glass frit employed in conventional conductive pastes, such as borosilicate glass frits. A borosilicate-lead glass having a softening temperature which is at least 300°C but not above the firing temperature may be used as the glass frit. The firing temperature may be, for example, 800°C.

In the conductive paste of the invention, the glass frit content is not subject to any particular limitation and has a preferred lower limit, based on the overall conductive paste, of 0.1% by weight and a preferred upper limit of 20% by weight. At a glass frit content below 0.1% by weight, when the lines in a solar cell element are formed using the resulting conductive paste, the antireflection layer cannot be corroded, as a result of which the electrical conductivity may decrease. When the glass frit content exceeds 20% by weight, the proportion of conductive powder in the resulting conductive paste decreases, as a result of which the electrical conductivity of the lines and other features to be formed may decrease.

The conductive paste of the invention may include a material having a thickening effect.
Illustrative, non-limiting, examples of such materials having a thickening effect include thickening agents such as fatty acid amides and castor oil, and resins such as acrylic fine particles and ethyl cellulose.
Such a material having a thickening effect is included in an amount having a preferred upper limit of 3% by weight based on the overall conductive paste. At a content of this material in excess of 3% by weight, the residual carbon content after firing increases, which may worsen the electrical conductivity.

The conductive paste of the invention may contain a surface conditioner.
Illustrative, non-limiting, examples of suitable types of surface conditioner include hydroxyl group-containing high-polarity organic compounds such as 2,2-dimethyl-1,3-propanediol and 2-(hydroxymethyl)-2-ethyl-1,3-propanediol.
The preferred upper limit in the surface conditioner content is 30% by weight, based on the overall conductive paste. At a surface conditioner content in excess of 30% by weight, the drying rate slows, as a result of which the paste may flow during the drying step, lowering the aspect ratio after printing and drying.

Aside from the above-described material having a thickening effect and the above-described surface conditioner, to the extent that the residual carbon content after firing does not increase, the conductive paste of the invention may also include various types of additives known to the art as conventional conductive paste additives, such as dispersants (e.g., surfactants) and plasticizers (e.g., phthalate esters).

The method of manufacturing the conductive paste of the invention is not subject to any particular limitation, and is exemplified by a method in which the binder resin for a conductive paste of the invention, the above-described conductive powder, the above-described organic solvent, and other ingredients added as needed are mixed by a hitherto known mixing method.
Illustrative, non-limiting, methods of mixture include techniques which use a three-roll mill and techniques which use a bead mill.

No particular limitation is imposed on applications for the conductive paste of the invention. For example, the conductive paste of the invention may be used as a conductor paste for the purpose of forming electrodes, electrically conductive layers and electrically conductive lines in solar cell elements, ceramic electronic components and the like. Of these, because the use of the conductive paste of the invention enables high-aspect-ratio lines to be formed, thus making it possible to obtain solar cell elements having a high light-trapping ratio and an excellent energy conversion efficiency, use as a conductive paste for the purpose of forming electrically conductive layers or electrically conductive lines on the surface, that is, light-receiving surface of a solar cell element is preferred.
In a still further aspect, the invention also relates to a solar cell element having electrically conductive layers or electrically conductive lines obtained by firing the conductive paste of the invention.

### EFFECTS OF THE INVENTION

The invention is thus able to provide a binder resin for a conductive paste, which can be used to obtain a conductive paste having a high conductive powder dispersibility, an ability to form high-aspect-ratio lines, and a low residual carbon content after firing. The invention is also able to provide a conductive paste and a solar cell element produced using such a binder resin for a conductive paste.

### MODE FOR CARRYING OUT THE INVENTION

The embodiments of the invention are described below in greater detail by way of examples, although the invention is not limited by these examples.

### (Example 1)

### (1) Production of a Binder Resin (Methacrylic Resin) for a Conductive Paste

Fifty parts by weight of methyl methacrylate (MMA), 50 parts by weight of isobutyl methacrylate (IBMA), 3 parts by weight of bis(2-ethylhexyl) dithiophosphate (available as "Poslex DT -8" from SC Organic Chemical Co., Ltd.) and 100 parts by weight of butyl acetate as the organic solvent were mixed in a 2L separable flask equipped with a stirrer, a condenser, a thermometer, a hot-water bath and a nitrogen gas inlet, thereby giving a monomer mixture.
The resulting monomer mixture was bubbled for 20 minutes using nitrogen gas to remove dissolved oxygen, following which the temperature of the hot-water bath was raised to boiling while flushing the interior of the separable flask with nitrogen gas and stirring. Next, a solution of diacyl peroxide (available as "Peroyl 355" from NOF Corporation) as the polymerization initiator diluted with butyl acetate was added. In addition, a butyl acetate solution containing the polymerization initiator was added a plurality of times during polymerization. Three parts by weight of the polymerization initiator was added per 100 parts by weight of the (meth)acrylate monomer.
Seven hours after the start of polymerization, the system was cooled to room temperature, bringing polymerization to completion. A butyl acetate solution of a binder resin for a conductive paste was obtained in this way. The resulting resin was analyzed by gel permeation chromatography using an LF-804 column (from Shoko Co., Ltd.), whereupon the polystyrene-equivalent number-average molecular weight was 15,000.

### (2) Production of Conductive Paste

The resulting butyl acetate solution of the binder resin for a conductive paste was dried, following which 6 parts by weight of this binder resin for a conductive paste, 80 parts by weight of silver powder (average particle size, 1.0 µm) as the conductive powder, 3 parts by weight of glass frit and 11 parts by weight of terpineol as the organic solvent were mixed together, then kneaded using a high-speed agitator and a three-roll mill, thereby giving a conductive paste.

### (Example 2)

In the production of a binder resin for a conductive paste, aside from using diethyl dithiophosphate (available from Wako Pure Chemical Industries) instead of bis(2-ethylhexyl) dithiophosphate, a binder resin for a conductive paste and a conductive paste were obtained in the same way as in Example 1.

### (Example 3)

In the production of a binder resin for a conductive paste, aside from using dipropyl dithiophosphate (available from Wako Pure Chemical Industries) instead of bis(2-ethylhexyl) dithiophosphate, a binder resin for a conductive paste and a conductive paste were obtained in the same way as in Example 1.

### (Example 4)

In the production of a binder resin for a conductive paste, aside from using 80 parts by weight of isobutyl methacrylate and 20 parts by weight of methoxypolyethylene glycol monomethacrylate ("Light Ester 041MA", available from Kyoeisha Chemical) instead of 50 parts by weight of methyl methacrylate and 50 parts by weight of isobutyl methacrylate, a binder resin for a conductive paste and a conductive paste were obtained in the same way as in Example 1.

### (Example 5)

In the production of a binder resin for a conductive paste, aside from changing the amount of bis(2-ethylhexyl) dithiophosphate from 3 parts by weight to 0.01 parts by weight, a binder resin for a conductive paste and a conductive paste were obtained in the same way as in Example 1.

### (Example 6)

In the production of a binder resin for a conductive pasts, aside from changing the amount of bis(2-ethylhexyl) dithiophosphate from 3 parts by weight to 30 parts by weight, a binder resin for a conductive paste and a conductive paste were obtained in the same way as in Example 1.

### (Example 7)

In the production of a binder resin for a conductive paste, aside from using 15 parts by weight of methyl methacrylate, 60 parts by weight of isobutyl methacrylate and 25 parts by weight of methoxypolyethylene glycol monomethacrylate instead of 50 parts by weight of methyl methacrylate and 50 parts by weight of isobutyl methacrylate, a binder resin for a conductive paste and a conductive paste were obtained in the same way as in Example 1.

### (Example 8)

In the production of a binder resin for a conductive paste, aside from using 70 parts by weight of methyl methacrylate and 30 parts by weight of isobutyl methacrylate instead of 50 parts by weight of methyl methacrylate and 50 parts by weight of isobutyl methacrylate, and aside from using diethyl dithiophosphate instead of bis(2-ethylhexyl) dithiophosphate, a binder resin for a conductive paste was obtained in the same way as in Example 1. Three parts by weight of this binder resin for a conductive paste, 85 parts by weight of silver powder (average particle size, 1.0 µm) as the conductive powder, 3 parts by weight of glass frit and 9 parts by weight of Texanol as the organic solvent were mixed together, then kneaded using a high-speed agitator and three-roll mill, thereby giving a conductive paste.

### (Example 9)

In the production of a binder resin for a conductive paste, aside from using diethyl dithiophosphate (available from Wako Pure Chemical Industries) instead of bis(2-ethylhexyl) dithiophosphate, a binder resin for a conductive paste was obtained in the same way as in Example 1. Three parts by weight of this binder resin for a conductive paste, 85 parts by weight of silver powder (average particle size, 1.0 µm) as the conductive powder, 4 parts by weight of glass frit, 7 parts by weight of butyl carbitol acetate as the organic solvent and 1 part by weight of fatty acid amide ("Disparlon 6300", available from Kusumoto Chemicals, Ltd.) were mixed together, then kneaded using a high-speed agitator and three-roll mill, thereby giving a conductive paste.

### (Example 10)

In the production of a binder resin for a conductive paste, aside from using 40 parts by weight of methyl methacrylate and 60 parts by weight of isobutyl methacrylate instead of 50 parts by weight of methyl methacrylate and 50 parts by weight of isobutyl methacrylate, and aside from using diethyl dithiophosphate instead of bis(2-ethylhexyl) dithiophosphate, a binder resin for a conductive paste was obtained in the same way as in Example 1. Five parts by weight of this binder resin for a conductive paste, 83 parts by weight of silver powder (average particle size, 1.0 µm) as the conductive powder, 3 parts by weight of glass frit, 8 parts by weight of butyl carbitol acetate as the organic solvent and 1 part by weight of castor oil ("Disparlon 308", available from Kusumoto Chemicals, Ltd.) were mixed together, then kneaded using a high-speed agitator and three-roll mill, thereby giving a conductive paste.

### (Example 11)

In the production of a binder resin for a conductive paste, aside from using 40 parts by weight of methyl methacrylate and 60 parts by weight of isobutyl methacrylate instead of 50 parts by weight of methyl methacrylate and 50 parts by weight of isobutyl methacrylate, and aside from using diethyl dithiophosphate instead of bis(2-ethylhexyl) dithiophosphate, a binder resin for a conductive paste was obtained in the same way as in Example 1. Four parts by weight of this binder resin for a conductive paste, 85 parts by weight of silver powder (average particle size, 1.0 µm) as the conductive powder, 2 parts by weight of glass frit, 7 parts by weight of Texanol as the organic solvent and 2 parts by weight of acrylic fine particles (Techpolymer MBX-5) were mixed together, then kneaded using a high-speed agitator and three-roll mill, thereby giving a conductive paste.

### (Example 12)

In the production of a binder resin for a conductive paste, aside from using 10 parts by weight of methyl methacrylate and 90 parts by weight of isobutyl methacrylate instead of 50 parts by weight of methyl methacrylate and 50 parts by weight of isobutyl methacrylate, and aside from using 2 parts by weight of diethyl dithiophosphate instead of 3 parts by weight of bis(2-ethylhexyl) dithiophosphate, a binder resin for a conductive paste was obtained in the same way as in Example 1. Four parts by weight of this binder resin for a conductive paste, 84 parts by weight of silver powder (average particle size, 1.0 µm) as the conductive powder, 3 parts by weight of glass frit, 8 parts by weight of benzyl alcohol as the organic solvent and 1 part by weight of ethyl cellulose resin ("STD-10", available from Dow Chemical) were mixed together, then kneaded using a high-speed agitator and three-roll mill, thereby giving a conductive paste.

### (Example 13)

In the production of a binder resin for a conductive paste, aside from using 100 parts by weight of isobutyl methacrylate instead of 50 parts by weight of methyl methacrylate and 50 parts by weight of isobutyl methacrylate, and aside from using diethyl dithiophosphate instead of bis(2-ethylhexyl) dithiophosphate, a binder resin for a conductive paste was obtained in the same way as in Example 1. Two parts by weight of this binder resin for a conductive paste, 86 parts by weight of silver powder (average particle size, 1.0 µm) as the conductive powder, 4 parts by weight of glass frit, 5 parts by weight of Texanol as the organic solvent and 3 parts by weight of 2,2-dimethyl-1,3-propanediol were mixed together, then kneaded using a high-speed agitator and three-roll mill, thereby giving a conductive paste.

### (Example 14)

Three parts by weight of the binder resin for a conductive paste obtained in Example 1, 85 parts by weight of silver powder (average particle size, 1.0 µm) as the conductive powder, 3 parts by weight of glass frit, 7 parts by weight of phenyl propylene glycol as the organic solvent and 2 parts by weight of 2-(hydroxymethyl)-2-ethyl-1,3-propanediol were mixed together, then kneaded using a high-speed agitator and three-roll mill, thereby giving a conductive paste.

### (Comparative Example 1)

In the production of a conductive paste, aside from using 4 parts by weight of ethyl cellulose ("STD-10", available from Dow Chemical) instead of the binder resin (methacrylic resin) for a conductive paste that was produced, and aside from changing the amount of terpineol added from 11 parts by weight to 13 parts by weight, a conductive paste was obtained in the same way as in Example 1.

### (Comparative Example 2)

In the production of a binder resin for a conductive paste, aside from using 0.5 parts by weight of dodecylmercaptan instead of 3 parts by weight of bis(2-ethylhexyl) dithiophosphate, a binder resin for a conductive paste and a conductive paste were obtained in the same way as in Example 1.

### (Comparative Example 3)

In the production of a binder resin for a conductive paste, aside from changing the amount of methyl methacrylate added from 50 parts by weight to 44 parts by weight, also adding 6 parts by weight of 2-(methacryloyloxy)ethyl phosphate ("Phosmer M", available from Uni-Chemical) represented by formula (5) below, and using 0.5 parts by weight of dodecylmercaptan instead of 3 parts by weight of bis(2-ethylhexyl) dithiophosphate, a binder resin for a conductive paste and a conductive paste were obtained in the same way as in Example 1.

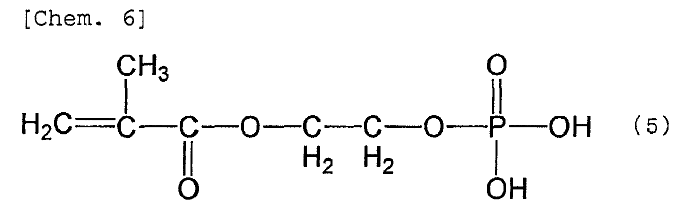

### (Comparative Example 4)

In the production of a binder resin for a conductive paste, aside from using 0.5 parts by weight of dodecylmercaptan instead of 3 parts by weight of bis(2-ethylhexyl) dithiophosphate, a binder resin for a conductive paste was obtained in the same way as in Example 1.
Also, in the production of a conductive paste, aside from changing the amount of terpineol added from 11 parts by weight to 10 parts by weight, and also adding 1 part by weight of a phosphoric acid-based dispersant ("BYK-111", available from Byk Chemie GmbH), a conductive paste was obtain in the same way as in Example 1.

### (Example 15)

### (1) Production of a Binder Resin (Methacrylic Resin) for a Conductive Paste

Fifty parts by weight of methyl methacrylate (MMA), 50 parts by weight of isobutyl methacrylate (IBMA), 0.5 parts by weight of bis(2-ethylhexyl) dithiophosphate (available as "Poslex DT-8" from SC Organic Chemical Co., Ltd.) and 50 parts by weight of butyl acetate as the organic solvent were mixed in a 2L separable flask equipped with a stirrer, a condenser, a thermometer, a hot-water bath and a nitrogen gas inlet, thereby giving a monomer mixture.
The resulting monomer mixture was bubbled for 20 minutes using nitrogen gas to remove dissolved oxygen, following which the temperature of the hot-water bath was raised to boiling while flushing the interior of the separable flask with nitrogen gas and stirring. A solution of diacyl peroxide (available as "Peroyl 355" from NOF Corporation) as the polymerization initiator diluted with butyl acetate was added. In addition, a butyl acetate solution containing the polymerization initiator was added a plurality of times during polymerization. Three parts by weight of the polymerization initiator was added per 100 parts by weight of the (meth)acrylate monomer.
Seven hours after the start of polymerization, the system was cooled to room temperature, bringing polymerization to completion. A butyl acetate solution of a binder resin for a conductive paste was obtained in this way. The resulting resin was analyzed by gel permeation chromatography using an "LF-804" column (from Shoko Co., Ltd.), whereupon the polystyrene-equivalent number-average molecular weight was 30,000.

### (2) Production of Conductive Paste

The resulting butyl acetate solution of the binder resin for a conductive paste was dried, following which 6 parts by weight of this binder resin for a conductive paste, 80 parts by weight of silver powder (average particle size, 1.0 µm) as the conductive powder, 3 parts by weight of glass frit, and 11 parts by weight of terpineol as the organic solvent were mixed together, then kneaded using a high-speed agitator and a three-roll mill, thereby giving a conductive paste.

### (Example 16)

In the production of a binder resin for a conductive paste, aside from changing the amount of bis(2-ethylhexyl) dithiophosphate from 0.5 parts by weight to 20 parts by weight and changing the amount of butyl acetate added from 50 parts by weight to 200 parts by weight, a binder resin for a conductive paste and a conductive paste were obtained in the same way as in Example 15.

### (Example 17)

In the production of a binder resin for a conductive paste, aside from changing the amount of butyl acetate added from 50 parts by weight to 20 parts by weight, a binder resin for a conductive paste and a conductive paste were obtained in the same way as in Example 15.

### (Example 18)

In the production of a binder resin for a conductive paste, aside from changing the amount of bis(2-ethylhexyl) dithiophosphate from 0.5 parts by weight to 20 parts by weight and changing the amount of butyl acetate added from 50 parts by weight to 400 parts by weight, a binder resin for a conductive paste and a conductive paste were obtained in the same way as in Example 15.

### (Example 19)

After drying the butyl acetate solution of the binder resin for a conductive paste obtained in Example 15, 3 parts by weight of this binder resin for a conductive paste, 85 parts by weight of silver powder (average particle size, 1.0 µm) as the conductive powder, 3 parts by weight of glass frit and 9 parts by weight of terpineol as the organic solvent were mixed together, then kneaded using a high-speed agitator and three-roll mill, thereby giving a conductive paste.

### (Example 20)

After drying the butyl acetate solution of the binder resin for a conductive paste obtained in Example 16, 4 parts by weight of this binder resin for a conductive paste, 85 parts by weight of silver powder (average particle size, 1.0 µm) as the conductive powder, 3 parts by weight of glass frit and 8 parts by weight of terpineol as the organic solvent were mixed together, then kneaded using a high-speed agitator and three-roll mill, thereby giving a conductive paste.

### (Example 21)

After drying the butyl acetate solution of the binder resin for a conductive paste obtained in Example 17, 3 parts by weight of this binder resin for a conductive paste, 85 parts by weight of silver powder (average particle size, 1.0 µm) as the conductive powder, 3 parts by weight of glass frit and 9 parts by weight of terpineol as the organic solvent were mixed together, then kneaded using a high-speed agitator and three-roll mill, thereby giving a conductive paste.

### (Example 22)

After drying the butyl acetate solution of the binder resin for a conductive paste obtained in Example 18, 4 parts by weight of this binder resin for a conductive paste, 85 parts by weight of silver powder (average particle size, 1.0 µm) as the conductive powder, 3 parts by weight of glass frit and 8 parts by weight of terpineol as the organic solvent were mixed together, then kneaded using a high-speed agitator and three-roll mill, thereby giving a conductive paste.

The monomer compositions, glass transition temperatures and number-average molecular weights of the binder resins for conductive pastes obtained in the respective examples and comparative examples are shown in Tables 1 and 2. The compositions of the conductive pastes obtained in the respective examples and comparative examples are shown in Tables 3 and 4.

### (Evaluations)

The following evaluations were carried out on the conductive pastes obtained in the examples and the comparative examples. The results are shown in Tables 3 and 4.

### (1) Dispersibility

After allowing the conductive pastes obtained in the examples and the comparative examples to stand for 24 hours, the conductive paste in each case was stirred using a bamboo skewer to check the dispersed or precipitated state of the conductive powder, and the dispersibility was rated according to the following criteria.
⊚: The conductive powder was dispersed; no settling at the bottom was observed
o: The conductive powder had precipitated, but could be re-dispersed
×: The conductive powder had precipitated and solidified; re-dispersion was impossible

### (2) Printability

Using the conductive pastes obtained in the examples and the comparative examples, a pattern of 100 µm lines and 150 µm spaces was screen-printed with a printing machine, and the state of the resulting line pattern was rated according to the following criteria.
O: Accurate lines were drawn
△: No line disconnects or contact with neighboring lines, but the line width varied
×: The lines had disconnects or were in contact with neighboring lines

### (3) Evaluation of Printed Line Aspect Ratio

Using the conductive pastes obtained in the examples and the comparative examples, a pattern of 100 µm lines and 150 µm spaces was screen-printed on a glass substrate with a printing machine. The line heights and widths in the resulting line pattern were measured with a laser microscope, and rated according to the following criteria.
o: The line width was 120 µm or less, and the line height was 20 µm or more
△: The line width was 120 µm or less and the average line height was 20 µm or more; however, the line height was irregular and less than 20 µm in places
×: The line width exceeded 120 µm or the average line height was less than 20 µm

### (4) Firing Evaluation

In accordance with the compositions shown for the examples and the comparative examples, a prepared binder resin (methacrylic resin) for a conductive paste or ethyl cellulose (STD10) as the binder resin, terpineol as the organic solvent and a phosphoric acid-based dispersant (BYK-111, from Byk Chemie) were mixed to produce a vehicle, and the resulting vehicle was dried at 150°C for 2 hours, giving a resin. The resulting resin was measured with a TG-DTA and rated according to the following criteria.
○: When heated to 600°C, the residual carbon content was 1% by weight or less
×: When heated to 600°C, a carbon content of more than 1% by weight remained

**[Table 1]**

| | Monomer composition (parts by weight). | | | | | | | | Glass Transition Temperature | Number-averageMolecular (°C) weight |
|---|---|---|---|---|---|---|---|---|---|---|
| | Methyl methacrylate | Isobutyl methacrylate | Methoxypolyethylene monomethacrylate | 2-(Methacryloyloxy)ethyl phosphate | Bis(2-ethylhexyl) dithiophosphate | Diethyl dithiophosphate | Dipropyl dithiophosphate | Dodecylmercaptan | | |
| Example 1 | 50 | 50 | - | - | 3 | - | - | - | 79 | 15000 |
| Example 2 | 50 | 50 | - | - | - | 3 | - | - | 79 | 19000 |
| Example 3 | 50 | 50 | - | - | - | - | 3 | - | 79 | 17000 |
| Example 4 | - | 80 | 20 | - | 3 | - | - | - | 13 | 16000 |
| Example 5 | 50 | 50 | - | - | 0.01 | - | - | - | 79 | 28000 |
| Example 6 | 50 | 50 | - | - | 30 | - | - | - | 79 | 14000 |
| Example 7 | 15 | 60 | 25 | - | 3 | - | - | - | 3 | 15000 |
| Example 8 | 70 | 30 | - | - | - | 3 | - | - | 87 | 15000 |
| Example 9 | 50 | 50 | - | - | - | 3 | - | - | 79 | 15000 |
| Example 10 | 40 | 60 | - | - | - | 3 | - | - | 75 | 15000 |
| Example 11 | 40 | 60 | - | - | - | 3 | - | - | 75 | 15000 |
| Example 12 | 10 | 90 | - | - | - | 2 | - | - | 62 | 15000 |
| Example 13 | - | 100 | - | - | - | 3 | - | - | 57 | 15000 |
| Example 14 | 50 | 50 | - | - | 3 | - | - | - | 79 | 15000 |
| Comparative Example 1 | - | - | - | - | - | - | - | - | - | - |
| Comparative Example 2 | 50 | 50 | - | - | - | - | - | 0.5 | 79 | 15000 |
| Comparative Example 3 | 44 | 60 | - | 6 | - | - | - | 0.5 | 75 | 14000 |
| Comparative Example 4 | 50 | 50 | - | - | - | - | - | 0.5 | 79 | 14000 |

**[Table 2]**

| | Monomer composition (parts by weight) | | | Glass Transition Temperature (°C) | Number-average Molecular weight |
|---|---|---|---|---|---|
| | Methyl methacrylate | Isobutyl methacrylate | Bis(2-ethylhexyl) dithiophosphate | | |
| Example 15 | 50 | 50 | 0.5 | 79 | 30000 |
| Example 16 | 50 | 50 | 20 | 79 | 5000 |
| Example 17 | 50 | 50 | 0.5 | 79 | 50000 |
| Example 18 | 50 | 50 | 20 | 79 | 3000 |
| Example 19 | 50 | 50 | 0. 5 | 79 | 30000 |
| Example 20 | 50 | 50 | 20 | 79 | 5000 |
| Example 21 | 50 | 50 | 0.5 | 79 | 50000 |
| Example 22 | 50 | 50 | 20 | 79 | 3000 |

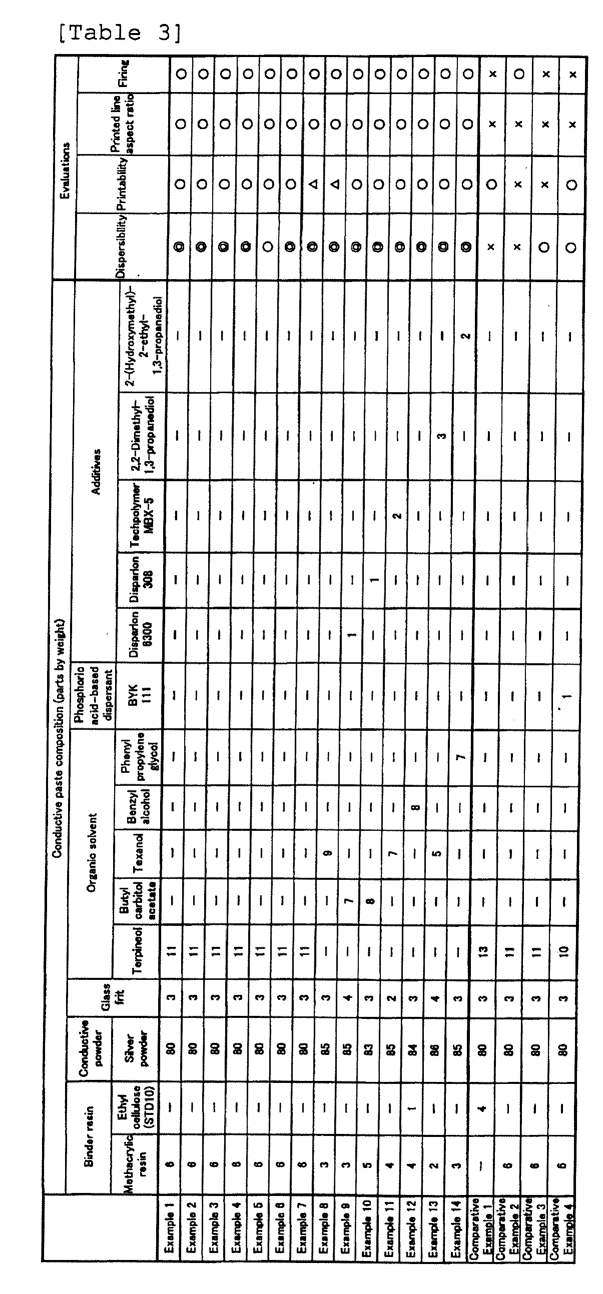

**[Table 4]**

| | Conductive paste composition (parts by weight) | | | | Evaluations | | | |
|---|---|---|---|---|---|---|---|---|
| | Binder resin | Conductive powder | Glass flit | Organic solvent | Dispersibility | Printability | Printed line aspect ratio | Firing |
| | Methacrylic resin | Silver powder | | Terpineol | | | | |
| Example 15 | 6 | 80 | 3 | 11 | ⊚ | ○ | ○ | ○ |
| Example 16 | 6 | 80 | 3 | 11 | ⊚ | ○ | ○ | ○ |
| Example 17 | 6 | 80 | 3 | 11 | ○ | △ | △ | ○ |
| Example 18 | 6 | 80 | 3 | 11 | ⊚ | ○ | △ | ○ |
| Example 19 | 3 | 85 | 3 | 9 | ⊚ | ○ | ○ | ○ |
| Example 20 | 4 | 85 | 3 | 8 | ⊚ | ○ | ○ | ○ |
| Example 21 | 3 | 85 | 3 | 9 | ⊚ | △ | △ | ○ |
| Example 22 | 4 | 85 | 3 | 8. | ⊚ | ○ | △ | ○ |

### INDUSTRIAL APPLICABILITY

The invention is able to provide a binder resin for a conductive paste, which can be used to obtain a conductive paste having a high conductive powder dispersibility, an ability to form high-aspect-ratio lines, and a low residual carbon content after firing. The invention is also able to provide a conductive paste and a solar cell element produced using such a binder resin for a conductive paste.

## Claims

1. A binder resin for a conductive paste,
which comprises a polymer having a main chain composed of a segment derived from a (meth)acrylate monomer and having also a phosphoric acid-based component represented by general formula (1) below at any ω position thereon: 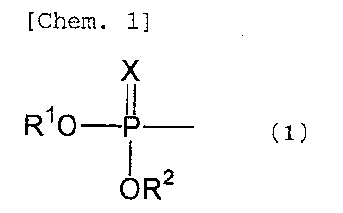 in general formula (1), X is an oxygen atom or a sulfur atom, and R¹ and R² are each a hydrogen atom, a hydrocarbon group having 1 to 13 carbon atoms, a hydroxyl group-containing group having 1 to 13 carbon atoms or an ester bond-containing group having 1 to 13 carbon atoms.

2. The binder resin for a conductive paste according to claim 1,
which has a number-average molecular weight of from 5,000 to 30,000.

3. The binder resin for a conductive paste according to claim 1 or 2,
which has a glass transition temperature of from 10 to 80°C.

4. The binder resin for a conductive paste according to claim 1, 2 or 3,
which, when heated to 600°C at a rate of temperature rise of 10°C/min, has a residual carbon content of 1% by weight or less.

5. The binder resin for a conductive paste according to claim 1, 2, 3 or 4,
wherein the content of a phosphoric acid-based component other than the phosphoric acid-based component at the ω position is less than 5% by weight of the overall polymer.

6. A conductive paste comprising: the binder resin for a conductive paste according to claim 1, 2, 3, 4 or 5; a conductive powder; and an organic solvent.

7. The conductive paste according to claim 6, wherein the conductive powder is a silver powder.

8. A solar cell element comprising an electrically conductive layer or an electrically conductive line obtained by firing the conductive paste according to claim 6 or 7.
